# EUROPEAN PATENT APPLICATION

(11) **EP 1 404 017 A1**
(43) Date of publication of application: **31.03.2004**
(21) Application number: 02021903.6
(22) Date of filing: 27.09.2002
(51) Int. Cl.: H03H 17/04, H03H 17/02

(54) **Parametric recursive digital filter**

(71) Applicant: Harman/Becker Automotive Systems GmbH, 94315 Straubing (DE)
(72) Inventor: Christoph, Markus, 94315 Straubing (DE)
(74) Representative: Schmuckermaier, Bernhard

(57) **Abstract**

Filter comprising a delay unit, the phase angle of which can be controlled and which comprises a delay element and a phase network interconnected therewith, and with positive feedback and feedback networks connected to the delay unit, the feedback path of the feedback network being connected to the output of the delay element in the delay unit and the cut-off frequency/centre frequency of the filter being adjustable via the phase angle of the delay unit.

## Description

The invention relates to a parametric recursive digital filter having at least one delay unit and a coefficient network connected to the delay unit or the delay units, respectively.

Digital filters having different filter structures and in various configurations are known, for example, from U. Tietze, Ch. Schenk, Halbleiterschaltungstechnik, (semiconductor circuit technology), 9th edition, 1991, pages 791 to 851, and consist of at least one delay unit formed of a delay element and one coefficient network determining the filter structure and the transfer characteristic including cut-off and centre frequencies. In numerous applications, it is necessary to change the cut-off or centre frequency of a filter in dependence on a control quantity (parametric filter).

In conventional digital filters, the cut-off or centre frequency is controlled either with the aid of coefficient tables or real-time calculation of the filter coefficients. This results in very high computing or memory complexity, particularly in the higher-order filters.

In W. Schüssler, W. Winkelnkemper, "Variable Digital Filters", Arch. Elektr. Übertr., Vol. 24, 1970, issue 11, pages 524-525, an arrangement is proposed in which the delay elements of a conventional digital filter are replaced by all-pass filters in order to obtain a parametric filter.

At the end of the article, however, the authors concede that, as a rule, this procedure cannot be implemented in digital filters since the all-pass filters comprise an attenuation when the highest all-pass filter coefficient is not equal to zero. As a solution for this problem, it is suggested either to use only all-pass filters in which the highest all-pass filter coefficient is equal to zero or only to use non-recursive filter structures. Using this proposed solution, however, only a few and only special filters can be implemented so that the possible applications are very limited.

It is the object of the invention to specify a parametric recursive digital filter which can be implemented without the abovementioned restrictions.

The object is achieved by a parametric recursive digital filter according to Patent Claim 1. Embodiments and further developments of the concept of the invention are the subject-matter of subclaims.

It is an advantage of the invention that the cut-off frequencies of recursive digital filters of otherwise any other configuration can be controlled by changing a single coefficient and this one coefficient can be determined by a very simple method of calculation. In particular, a very uncomplicated calculation is obtained from the fact that, as an approximation, a linear relationship exists between this one coefficient and the cut-off or centre frequency, respectively.

The parametric digital filter according to the invention can be implemented by means of any recursive filter structure including digital wave filter structures. It is also advantageous that in each case a filter element with controllable phase angle (e.g. all-pass filter, Laguerre-Kautz-Filter) is in each provided as the delay unit. The filter structure of the digital filter according to the invention is determined by the coefficient network as is customary, but the associated cut-off frequency/centre frequency can be adjusted via the phase angle of the filter element or of the filter elements, that is to say preferably via only a single coefficient.

According to the invention, in detail, a parametric recursive digital filter of the type initially mentioned is proposed which comprises
- a delay unit, the phase angle of which is controllable and which comprises a delay element and a phase network interconnected therewith,
- a positive feedback network connected to the delay unit and compriseing a positive feedback path,
- a feedback network connected to the delay unit and compriseing a feedback path,
- the feedback path of the feedback network being connected to the output of the delay element in the delay unit, and
- the cut-off frequency/centre frequency of the filter being adjustable via the phase angle of the delay unit.

In more complex filters and in higher-order filters, in particular, a plurality of delay units is used and the delay units can be formed preferably by identical filter elements selected in the same manner. As a result, all filter elements have the same coefficient so that the calculation of the coefficients only needs to be performed once and can be used for all filter elements. This saves considerable computing expenditure.

The delay units can comprise a plurality of, in particular two, delay elements. In addition, the positive feedback network can comprise a plurality of positive feedback paths and the feedback network can comprise a plurality of feedback paths.

In each case, an all-pass filter is preferably provided as a delay unit, and frequency-influencing filter units such as low-pass, bandpass, high-pass filters etc. can also be used with corresponding restrictions and/or special features in the characteristics.

An all-pass filter preferred for use as delay unit comprises the following:
- a first adder, one input of which forms the input of the delay unit,
- a second adder, the output of which forms the output of the delay unit,
- a coefficient section which is connected between the output of the first adder and a first input of the second adder,
- a first delay element which is connected between the input of the delay unit and a second input of the second adder,
- a second delay element which is connected between the output of the delay unit and a second input of the first adder,
- the phase angle of the filter element being adjustable by changing the coefficient of the coefficient section, and
- the output of the first and/or second delay element being provided for connecting a feedback path.

Apart from this embodiment of an all-pass filter which is of advantage for many applications, however, any other embodiment of an all-pass filter can also be used.

To achieve a low-expenditure filter, two delay units comprising delay elements can be interconnected with one another (in each case) in such a manner that only a total of three delay elements are provided, one delay element being used for both delay units.

In the text which follows, the invention will be explained in greater detail with reference to the illustrative embodiments shown in the figures of the drawing, in which:
- Figure 1: shows the signal flowcharts (structure) of two first-order all-pass filters,
- Figure 2: shows the phase response or frequency bending function, respectively, of a first-order all-pass filter as a function of the allpass filter coefficient,
- Figure 3: shows the frequency resolution of the parametric filter for various all-pass filter parameters,
- Figure 4: shows the structure of a conventional finite impulse response (FIR) filter,
- Figure 5: shows the structure of a corresponding parametric finite impulse response filter,
- Figure 6: shows the detailed, computationally efficient structure of a parametric FIR filter,
- Figure 7: shows the structure of a biquad filter as an example of a second-order infinite impulse response (IIR) filter before mapping,
- Figure 8: shows the structure of a biquad filter as an example of a second-order infinite impulse response (IIR) filter after mapping,
- Figure 9: shows the structure of parametric infinite impulse response filters with a low-pass filter as the first delay unit,
- Figure 10: shows the pole-zero shift in the Z domain as a function of the all-pass filter parameter in a second-order parametric IIR filter structure according to the invention,
- Figure 11: shows the pole-zero diagram of a prototype filter according to the invention,
- Figure 12: shows the amplitude/frequency response of the prototype filter according to Figure 11, and
- Figure 13: shows a computationally efficient version of a second-order parametric IIR filter according to the invention,
- Figure 14: shows the impulse response of a target filter for a second-order parametric IIR filter according to the invention,
- Figure 15: shows the resultant amplitude/frequency response of the target filter,
- Figure 16: shows the pole-zero diagram of the target filter.

Digital filters in which simple delay sections are replaced by frequency-dependent delay sections such as, e.g. a first-order all-pass filter, are often called frequency distorting filters since they represent filters, the specifications of which are implemented on a distorted nonuniform frequency axis.

A shift in the amplitude/frequency response |H(z)| can be achieved if z is replaced or mapped by an expression W(z), where W(z) must meet the following conditions:
- the inside of the unit circle (Z plane) must be mapped again to the inside of the inner circle.
- the unit circle must be mapped to itself.

The first condition means that, if H(z) is stable, H(W(z)) is also stable. The second condition makes it possible to shift or to "map" the amplitude/frequency response into another arbitrary frequency range.

W(z) must be clearly an all-pass filter since this meets both the above conditions. The amplitude/ frequency response |H(z)| of the all-pass filter which is constantly equal to one as is known ensures that the amplitude/frequency response of the overall filter is not changed and that the first condition is met, the phase response effecting the actual frequency displacement, i.e. being responsible for meeting the second condition. Thus, a displacement or bending of the frequency axis occurs, the displacement of which can be controlled by the filter coefficient of the first-order all-pass filter which is why the filter efficient γ of the first-order all-pass filter is also called frequency curvature parameter.

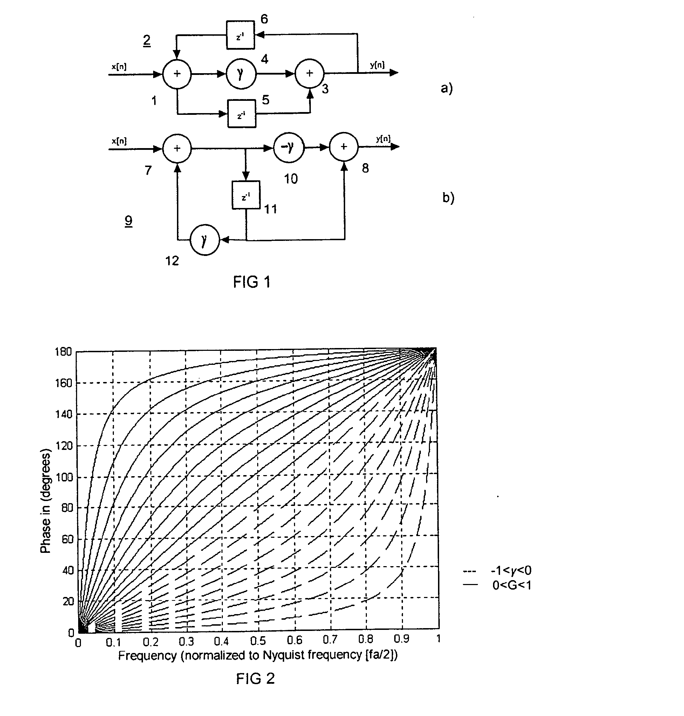

Figure 1 shows two examples of first-order all-pass filters.

Example (a) comprises a first adder 1, one input of which forms the input of a delay unit 2, and a second adder 3, the output of which forms the output of the delay unit 2. A coefficient section 4 is connected between the output of the first adder 1 and a first input of the second adder 3. A first delay element 5 is connected between the input of the delay unit 2 and a second input of the second adder 3. Finally, a second delay element 6 is also connected between the output of the delay unit 2 and a second input of the first adder 1.

The second example (b) again comprises a first adder 7, one input of which forms the input of a delay unit 9, and a second adder 8, the output of which forms the output of the delay unit 9. A first coefficient section 10 is connected between the output of the first adder 7 and a first input of the second adder 8. A single delay element 11 is connected between the output of the first adder 7 and a second input of the second adder 8. In addition, the output of the delay element 11 is conducted to the second input of the first adder 7 via a second coefficient section 12. The first coefficient section 10 comprises the coefficient -γ and the second coefficient section 12 comprises the coefficient γ.

A first-order all-pass filter has the following transfer function:$\text{W(z)} \text{=} \frac{\text{1-} {\text{γ*z}}^{\text{-1}}}{{\text{z}}^{\text{-1}} \text{-} \text{γ}}$

The first-order all-pass filter changes its phase response as a function of the all-pass parameter γ which can move within a range of -1 < γ < +1. The change of this frequency response, in turn, corresponds to the bending of the frequency axis or, respectively, its mapping into a new frequency range.

Figure 2 shows the frequency response or frequency bending function of the first-order all-pass filter as a function of the all-pass coefficient or frequency curvature parameter γ. It can be seen that high frequencies are mapped to low frequencies for negative γ values and low frequencies are mapped to high frequencies for positive γ values. The greater the amount of γ, the greater the frequency bending. There is no frequency bending at γ = 0, i.e. the frequency axis is mapped to itself again in this case (bisector).

Since delay elements in traditional filter structures do not appear in the form of z but in the form of z⁻¹, it is also appropriate for filters with frequency bending to work not with W(z) but with W⁻¹(z). In this way, it is impossible to replace all delay elements z⁻¹ with their frequency-dependent counterpart${\text{W}}^{\text{-1}} \text{(z) = D(z) =} \frac{{\text{z}}^{\text{-1}} \text{-} \text{γ}}{\text{1 -} \text{γ} \text{*} {\text{z}}^{\text{-1}}}$ in any filter structures. Although it is not quite correct that this applies to any filter structures, this question and its significance will be discussed in detail later.

Due to the bending of the frequency axis, some frequency ranges are resolved more finely and others more coarsely in dependence on the frequency curvature parameter γ.

If a filter has a local frequency resolution of Δf(f) before the "bending", the bent filter has a local frequency resolution of Δf_{w}(f), where the following holds true:$\text{Δ} {\text{ƒ}}_{\text{w}} \text{(ƒ) = Δƒ(} {\text{ƒ}}_{\text{w}} \text{(ƒ,γ))*} \frac{{\text{1-γ}}^{\text{2}}}{{\text{1+γ}}^{\text{2}} \text{+2*γ*cos(} \frac{\text{2*π*} {\text{ƒ}}_{\text{w}} \text{(ƒ,γ)}}{{\text{ƒ}}_{\text{s}}} \text{)}}$ where fₛ is the sampling frequency and f_{w}(f, γ) stands for a function which specifies the corresponding frequency in the bent frequency range for a given frequency and all-pass parameter. The frequency of the parametric filter as a function of the frequency and of the all-pass parameter γ is:${\text{ƒ}}_{\text{w}} \text{(ƒ, γ)} \text{= ƒ +} \frac{{\text{ƒ}}_{\text{s}}}{\text{π}} \text{* arctan(} \frac{\text{γ * sin(} \frac{\text{2*π*ƒ}}{{\text{ƒ}}_{\text{s}}} \text{)}}{\text{1-γ*cos (} \frac{\text{2*π*ƒ}}{{\text{ƒ}}_{\text{s}}} \text{)}} \text{)}$

The turning point frequency fₜₚ is the frequency at which the frequency resolution of the parametric filter is the same as before the frequency bending. It can be shown that the following holds true for fₜₚ:${\text{ƒ}}_{\text{tP}} \text{=} \frac{{\text{ƒ}}_{\text{s}}}{\text{2*π *}} \text{arccos(γ)}$

For frequencies below fₜₚ, the frequency resolution is improved with a positive γ. It worsens correspondingly for negative γ. Figure 1 shows in this respect the frequency resolution of the parametric filter for various all-pass parameters γ. The turning point frequency fₜₚ is given when the frequency resolution is equal to one.

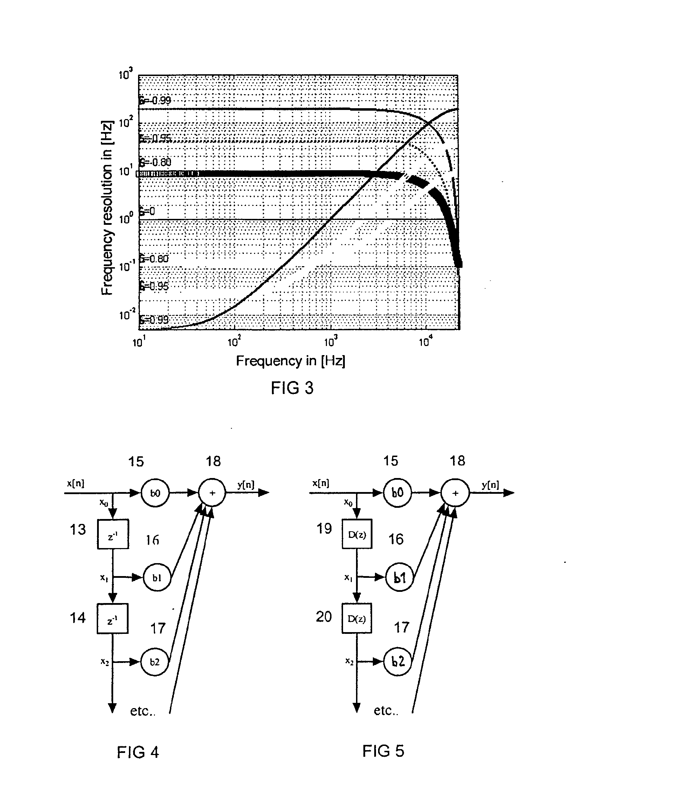

In an example of a traditional FIR (Finite Impulse Response) filter structure according to Figure 4, two delay elements 13, 14 are connected in series and driven with an input signal x[n], the taps of the delay elements 13, 14 etc. being supplied to an adder 18 at the output end via coefficient sections 15, 16, 17 etc., forming an output signal y[n]. The structure of a frequency-bending FIR filter is obtained by replacing each delay element 13, 14 etc. occurring in the traditional FIR filter structure (e.g. Figure 4) with a frequency-dependent delay element 19, 20 having a transfer function D(z).

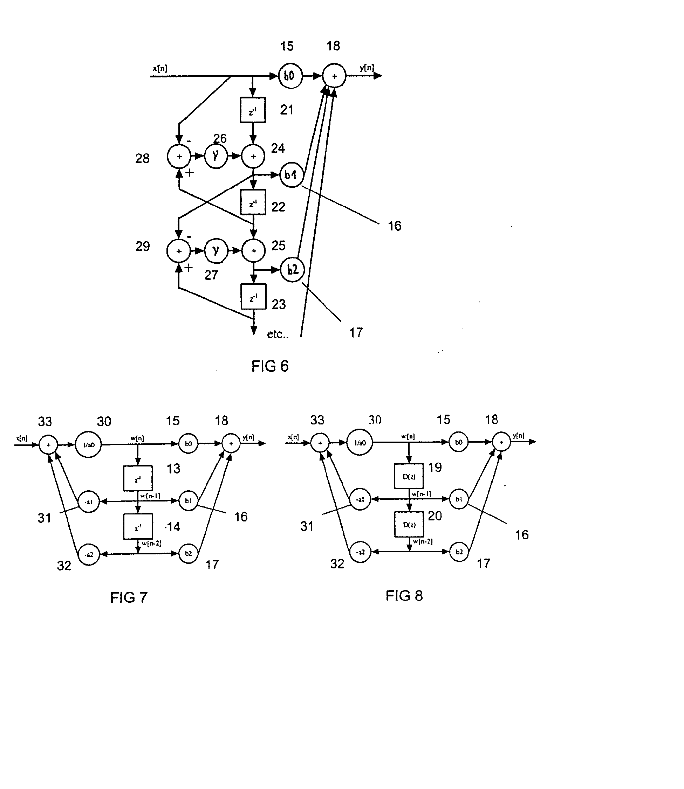

The structure of such a frequency-bending FIR filter is shown in Figure 5.

If then the frequency-dependent delay sections are replaced by their corresponding all-pass filter structure (e.g. by the structure shown in Figure 1a) and the structure is simplified by dissolving redundant branches, a computationally efficient structure of a frequency-bending FIR filter is obtained.

To this end, Figure 6 shows the detailed computationally efficient frequency-bending FIR structure for the general structure according to Figure 5. This structure comprises series-connected delay elements 21, 22, 23 etc., an addition node in the form of an adder 24, 25 etc. being inserted between in each case two delay elements 21, 22, 23 etc. The signals for the coefficient sections 21, 22, 23 etc. are picked up at the input of the delay element 21 and the outputs of the adders 24, 25 etc. The other input of each of the adders 24, 25 etc., which is still free in each case, is connected to the output of a subtractor 28, 29 etc. via a coefficient section 26, 27 etc. to which the coefficient γ (all-pass filter parameter γ) is applied.

The inputs of the subtractor 28 are connected to the input of the delay element 21 and to the output of the delay element 22. The inputs of the subtractor 29 are connected to the input of the delay element 22 and to the output of the delay element 23. The result is that, for example, the delay element 22 is used for two delay units (e.g. delay units 19 and 20 from Figure 5).

Replacing a delay element in one of the traditional IIR filter structures with a frequency-dependent (dispersive) delay element as has already been explained for the FIR filter provides a structure which contains feedback branches which are free of delay but which cannot be implemented in this way, as has been explained in the prior art mentioned initially.

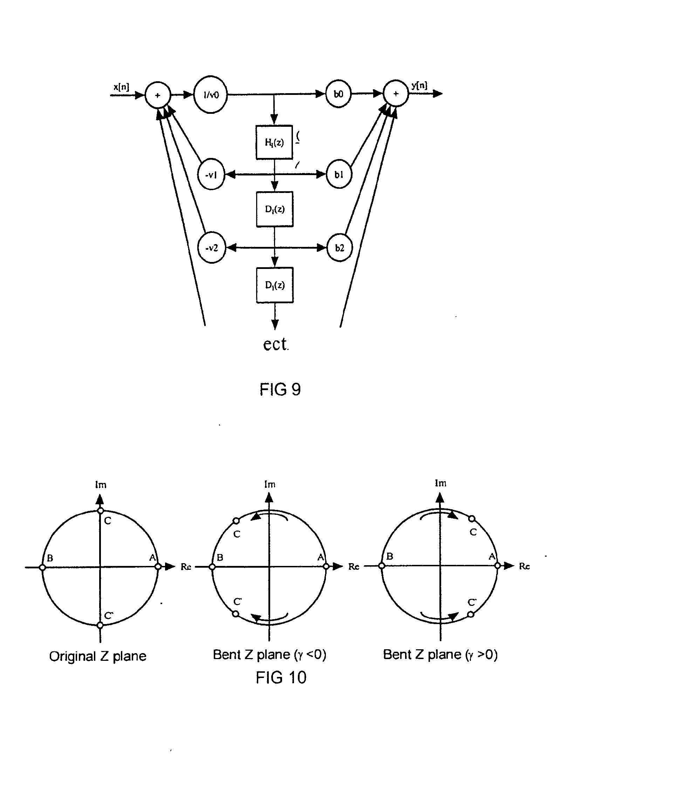

Figures 7 and 8 show a recursive biquad filter before and after the mapping.

Figure 7 is based on the arrangement according to Figure 4 due to the fact that the structure has been limited to a second-order structure and has been expanded by a feedback network. The feedback network comprises three coefficient sections 30, 31 and 32 which, on the one hand, are connected to the taps of the delay elements 13, 14 and, on the other hand, to two inputs of an adder 33 (coefficient sections 31 and 32) and to the output of the adder 33 (coefficient section 30). A third input of the adder 33 is driven with the input signal x[n].

Correspondingly, the filter shown in Figure 8 is based on the filter according to Figure 5, that is to say by limiting the structure to a second-order structure and expanding it by the same feedback network as in Figure 7.

A WIIR filter structure which is also suitable for higher filter orders provides for all other delay elements apart from the first one to be replaced by first-order all-pass filters, the first one being replaced by a first-order low-pass filter. This measure makes it necessary to recalculate (to map) the filter coefficients of the original IIR filter to the new structure which is done by means of a relatively simple recursive formula. Figure 9 shows the corresponding new IIR filter structure (Laguerre filter).

The achievable structure according to the invention now consists in replacing all delay elements with all-pass filters (particularly of the first order). However, to avoid the zero-delay feedbacks, feedback is not effected after the respective dispersive delay units (in the prior art) but, according to the invention, directly after the delay element within a dispersive delay unit. The forward branch (FIR part of the filter) with its coefficients b₀, b₁, b₂ etc. remains unaffected by this measure.

In the text which follows, the procedure in designing a second-order frequency-bending IIR filter is explained with the design of a 10 Hz high-pass filter.

Using frequency-bending filters, a fixed "prototype filter" can be designed which has an arbitrary fixed cut-off frequency fg and which can then be displaced into any desired frequency range with the aid of the frequency curvature parameter γ.

Figure 10 shows the pole-zero shift in the z domain as a function of the frequency curvature parameter γ.

Since originally filters are assumed which are designed in the direct form, it is appropriate to utilize the advantages of the direct form as far as possible. As is already known, the frequency range within which the direct form has particularly good characteristics in the sense of quantization sensitivity and dynamic range, is around fₐ/4. For this reason, the cut-off frequency of the prototype filter is firmly left at f_{g} = fₐ/4.

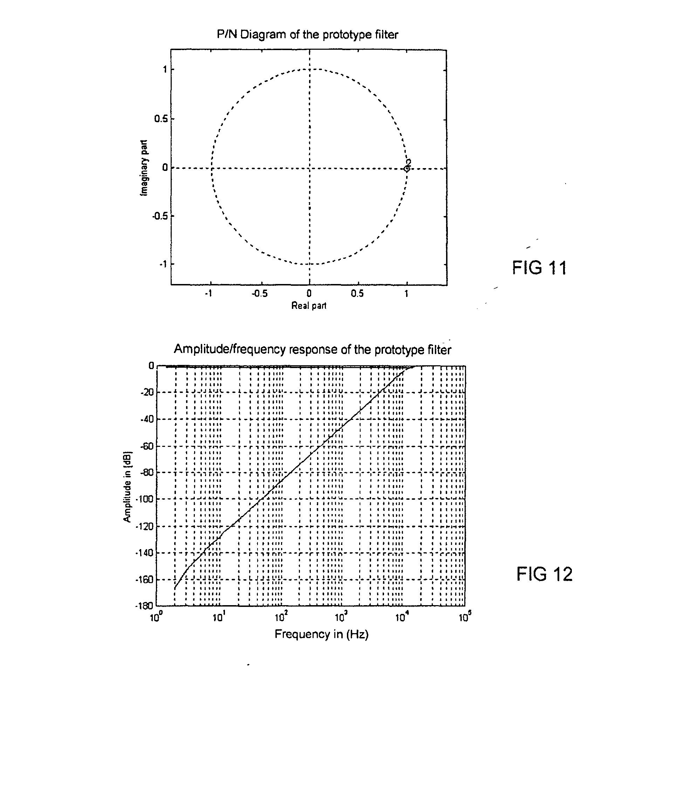

Figures 11 and 12 show the associated pole-zero diagram and the amplitude/frequency response of the prototype filter.

Next, the frequency curvature parameter γ must be calculated so that the prototype filter is shifted towards the required cut-off frequency. For this purpose, the abovementioned equation${\text{ƒ}}_{\text{pre}} \text{(} \text{ƒ,} \text{γ) = ƒ +} \frac{{\text{ƒ}}_{\text{s}}}{\text{π}} \text{*arctan (} \frac{\text{γ*sin (} \frac{\text{2*π*ƒ}}{{\text{ƒ}}_{\text{s}}} \text{)}}{\text{1-γ* cos(} \frac{\text{2*π} \text{*ƒ}}{{\text{ƒ}}_{\text{s}}} \text{)}} \text{)}$ can be transformed in such a manner that the necessary frequency curvature parameter γ can be calculated from it. The calculation formula which produces the frequency curvature parameter γ with the aid of the fixed cut-off frequency of the prototype filter fₚᵣₑ and the desired cut-off frequency f_{g} is:$\text{γ} \text{= -} \frac{\text{tan(} \frac{\text{(} {\text{ƒ}}_{\text{pre}} \text{-} {\text{ƒ}}_{\text{g}} \text{)*π}}{{\text{ƒ}}_{\text{a}}} \text{)}}{\text{sin(} \frac{\text{2*π*} {\text{ƒ}}_{\text{g}}}{{\text{ƒ}}_{\text{a}}} \text{) +cos(} \frac{\text{2*π*} {\text{ƒ}}_{\text{g}}}{{\text{ƒ}}_{\text{a}}} \text{)*tan(} \frac{\text{(} {\text{ƒ}}_{\text{pre}} \text{-} {\text{ƒ}}_{\text{g}} \text{*π}}{{\text{ƒ}}_{\text{a}}} \text{)}} \text{)}$

If fₚᵣₑ is firmly left at fₐ/4, the previous equation is reduced to:$\text{γ} \text{= tan(} \frac{\text{π}}{\text{4}} \text{-} \frac{{\text{ƒ}}_{\text{g}} \text{*π}}{{\text{ƒ}}_{\text{a}}} \text{)}$

The expression fₚᵣₑ for the fixed cut-off frequency of the prototype filter was selected since it can be said that this filter is designed in the distorted frequency range. One can return from the distorted frequency range into the original frequency range by operating the parametric filter with the frequency curvature parameters γ calculated above.

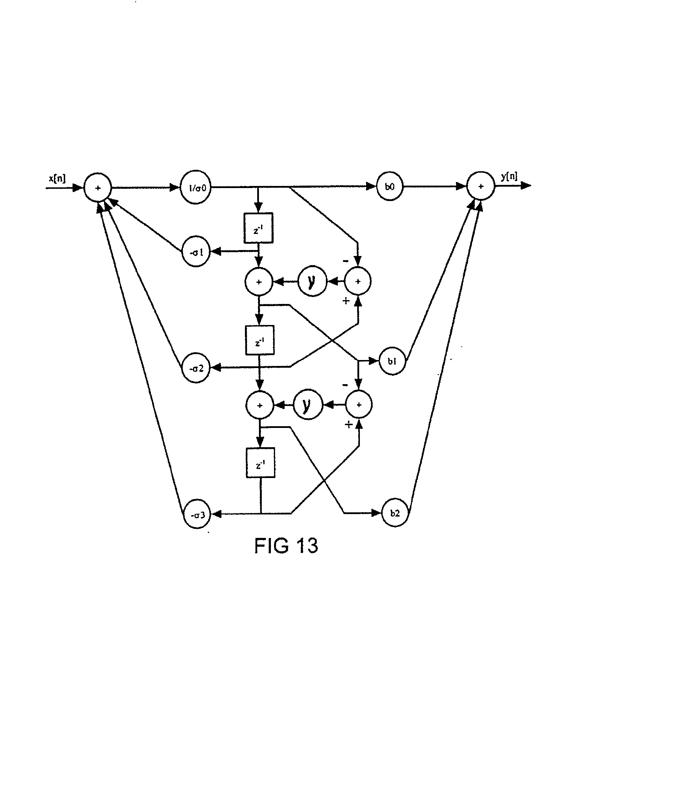

Figure 13 shows a computationally efficient embodiment of a second-order parametric IIR filter. This embodiment is obtained by expanding the arrangement according to Figure 6 correspondingly by one feedback network.

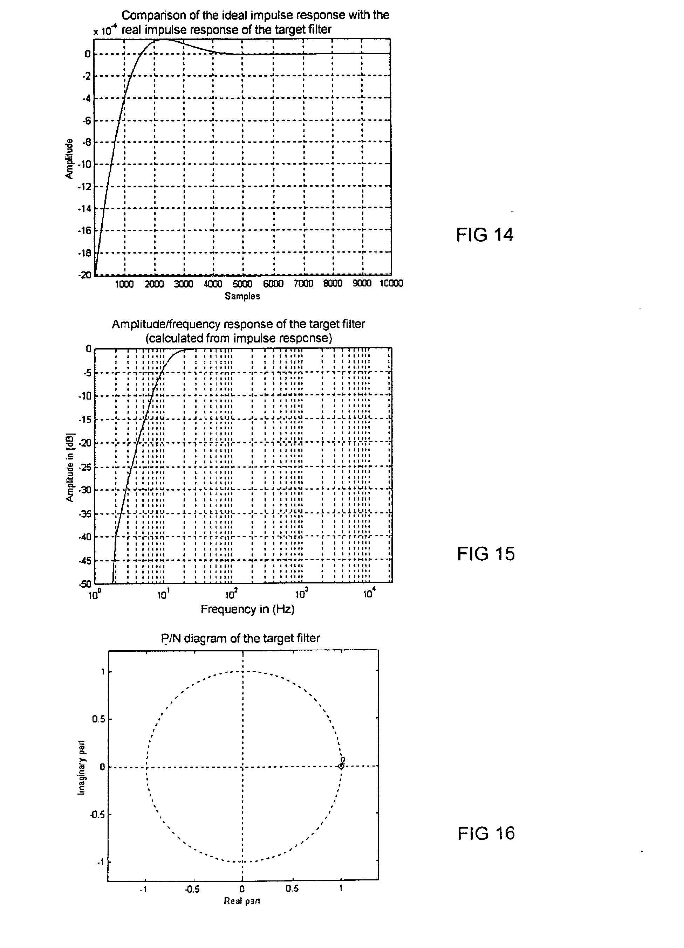

From the second-order parametric IIR filter, the impulse response shown in Figure 14 and the resultant amplitude/frequency response of the target filter shown in Figure 15 is obtained. The associated pole-zero diagram of the target filter is shown in Figure 16.

The abovementioned digital filters are preferably implemented in microprocessors, signal processors, microcontrollers, computing devices etc. The individual filter components such as, for example, delay units, delay elements, coefficient sections are then hardware components of the microprocessors, signal processors, microcontrollers, computing devices, etc. which are correspondingly used by means of software.

## Claims

1. Parametric recursive digital filter comprising a delay unit, the phase angle of which is controllable and which comprises a delay element and a phase network interconnected therewith,
a positive feedback network connected to the delay unit and compriseing a positive feedback path,
a feedback network connected to the delay unit and compriseing a feedback path,
the feedback path of the feedback network being connected to the output of the delay element in the delay unit, and
the cut-off frequency/centre frequency of the filter being adjustable via the phase angle of the delay unit.

2. Filter according to Claim 1, in which a plurality of delay units are provided.

3. Filter according to Claim 2, in which the delay units are identically designed and are controlled in the same manner.

4. Filter according to one of the preceding claims, in which the delay unit(s) comprise(s) a plurality of delay elements.

5. Filter according to one of the preceding claims, in which the positive feedback network comprises a plurality of positive feedback paths.

6. Filter according to one of the preceding claims, in which the feedback network comprises a plurality of feedback paths.

7. Filter according to one of the preceding claims, in which in each case an all-pass filter is provided as delay unit (s) .

8. Filter according to Claim 7, in which at least one delay unit constructed as all-pass filter comprises the following:
a first adder, one input of which forms the input of the delay unit,
a second adder, the output of which forms the output of the delay unit,
a coefficient section which is connected between the output of the first adder and a first input of the second adder,
a first delay element which is connected between the input of the delay unit and a second input of the second adder,
a second delay element which is connected between the output of the delay unit and a second input of the first adder,
the phase angle of the filter element being adjustable by changing the coefficient of the coefficient section, and
the output of the first and/or second delay element being provided for connecting a feedback path.

9. Filter according to one of Claims 2 to 9, in which two delay units comprising delay elements are (in each case) interconnected with one another in such a manner that only a total of three delay elements are provided, one delay element being attributable to both delay units.

10. Filter according to one of Claims 1 to 6, in which a frequency-influencing filter unit is provided as delay unit.
